# EUROPÄISCHE PATENTSCHRIFT

(11) **EP 0 920 055 B1**
(45) Veröffentlichungstag und Bekanntmachung des Hinweises auf die Patenterteilung: **30.11.2005**
(21) Anmeldenummer: 98115694.6
(22) Anmeldetag: 20.08.1998
(51) Int. Cl.: H05K 1/02, H05K 7/20

(54) **Kühlvorrichtung für ein auf einer Leiterplatte angeordnetes, wärmeerzeugendes Bauelement**
Cooling device for a heat generating component on a printed board
Dispositif de refroidissement pour un composant générant de la chaleur sur un circuit imprimé

(30) Priorität: 28.11.1997 DE 19752797
(43) Veröffentlichungstag der Anmeldung: 02.06.1999
(73) Patentinhaber: ROBERT BOSCH GMBH, 70442 Stuttgart (DE)
(72) Erfinder: Irschik, Heinz, 71665 Vaihingen (DE); Koelle, Gerhard, 75446 Wiernsheim (DE); Harrer, Wolfgang, 70839 Gerlingen (DE); Geiger, Albert, 71735 Eberdingen (DE)

(56) Entgegenhaltungen:
- EP-A- 0 590 354
- EP-A- 0 634 890
- DE-A- 4 107 312
- DE-A- 19 506 664
- FR-A- 2 706 730
- US-A- 5 014 904
- "INTERFACE MATERIALS OFFER HEAT TRANSFER AND ISOLATION" ELECTRONIC PACKAGING AND PRODUCTION, Bd. 35, Nr. 10, 1. September 1995, Seite 32 XP000532275

## Beschreibung

### Stand der Technik

Die Erfindung betrifft eine Kühlvorrichtung für ein auf einer Leiterplatte angeordnetes wärmeerzeugendes Bauelement mit den im Oberbegriff des Anspruchs 1 angegebenen Merkmalen; vgl. z. B. EP-A-0634890.

Kühlvorrichtungen für auf Leiterplatten angeordnete elektronische Leistungsbauelemente haben seit einiger Zeit aufgrund der sehr starken Wärmeentwicklung moderner Leistungsbauelemente eine stets wachsende Bedeutung gewonnen. Eine möglichst effektive Wäremabfuhr ist dabei insbesondere in elektronischen Steuergeräten von Kraftfahrzeugen erforderlich, um Fehlfunktionen der Steuerelektronik zu vermeiden. Problematisch ist, daß die wärmeerzeugenden Bauelemente in den meisten Fällen gegenüber dem Kühlkörper elektrisch isoliert werden müssen, wobei die isolierende Schicht den direkten Wärmeübergang auf den Kühlkörper erschwert. So ist beispielsweise aus der DE 41 07 312 A1 eine Kühlvorrichtung mit einem auf eine doppelseitig kupferkaschierte Leiterplatte aufgelöteten wärmeerzeugenden Bauelement bekannt. Die von dem Bauelement erzeugte Wärme wird über durchmetallisierte Bohrungen in der Leiterplatte, sogenannte Durchkontaktierungen, die mit Lötzinn aufgefüllt sind und unmittelbar unter der Montagefläche des Bauelementes angeordnet sind, auf die kupferkaschierte Unterseite der Leiterplatte abgeleitet. Die Leiterplatte ist mit ihrer kupferkaschierten Unterseite getrennt durch eine wärmeleitende elektrisch isolierende Schicht auf einen Kühlkörper aufgebracht. Nachteilig dabei ist, daß die elektrisch isolierende Schicht einen schnellen Übergang der durch die metallisierten Bohrungen abgeleiteten Wärme auf den Kühlkörper verhindert, da die Wärmeleitfähigkeit dieser Schicht schlechter ist als die metallische Wärmeleitfähigkeit der mit Lot gefüllten durchmetallisierten Bohrungen. Bei sehr starker Wärmeentwicklung ist daher beim Stand der Technik ein nachteiliger Wärmestau die Folge, der zu einer Überhitzung und Beschädigung der auf der Leiterplatte angeordneten Schaltung führen kann.

### Vorteile der Erfindung

Die erfindungsgemäße Kühlvorrichtung mit den kennzeichnenden Merkmalen des Anspruchs 1 vermeidet die beim Stand der Technik auftretenden Nachteile. Ein Wärmestau der durch die metallisierten Bohrungen auf die der Montageseite des Bauelementes gegenüberliegende zweite Seite der Leiterplatte abgeleiteten Wärme wird vorteilhaft dadurch vermieden, daß eine als Wärmesenke dienende Wärmeleitplatte direkt auf die zweite großflächige Metallisierung unterhalb der durchmetallisierten Bohrungen aufgelötet ist. Dadurch wird vorteilhaft erreicht, daß die Wärme direkt auf die Wärmeleitplatte abgeleitet wird und sich dort rasch verteilt. Die Schichtdicken der großflächigen Metallisierungen der Leiterplatte beträgt bei einer doppelseitig kupferkaschierten Leiterplatte in der Regel 30 bis 40 µm und kann mit den bekannten Herstellungsverfahren kaum größer als 80µm ausgelegt werden, weshalb die laterale Wärmeableitung dieser Schicht nicht sehr groß ist. Im Gegensatz dazu kann die Wärmeleitplatte deutlich dicker als die Metallisierungsschicht ausgelegt werden, so daß die laterale Wärmeableitung deutlich verbessert wird. Besonders vorteilhaft ist, daß insbesondere bei einer kurzzeitig auftretenden Wärmepulsbelastung die Wärme zunächst direkt auf die Wärmeleitplatte abgeleitet wird, sich dort verteilt und anschließend über die elektrisch isolierende, wärmeleitende Schicht an den Kühlkörper abgegeben wird.

Gemäß dem Anspruch 1 ist weiterhin, den auf den durchmetallisierten Bohrungen aufliegenden Bereich der Wärmeleitplatte mit sich durch die Wärmeleitplatte erstreckenden Ausnehmungen zu versehen. Durch die Ausnehmungen ist ein Teil der durchmetallisierten Bohrungen von der zweiten Seite der Leiterplatte aus frei zugänglich, so daß nach Auflage der Wärmeleitplatte von der zweiten Seite der Leiterplatte aus Lötzinn durch die Ausnehmungen in die durchmetallisierten Löcher eingefüllt werden kann. Da das in die Ausnehmungen eingefüllte Lötzinn an den Innenwandungen der Ausnehmungen haftet und gleichzeitig in die metallisierten Bohrungen eindringt, bilden sich Lotbrücken aus, die die Wärmeableitung auf die Wärmeleitplatte deutlich verbessern. Eine derartige Verlötung der Wärmeleitplatte mit der zweiten Metallisierung der Leiterplatte kann vorteilhaft im gut beherrschten Wellenlötverfahren zusammen mit der Verlötung von auf der zweiten Seite der Leiterplatte vorgesehenen Bauelementen durchgeführt werden.

Vorteilhaft ist weiterhin als Wärmeleitplatte eine Metallplatte aus Kupfer zu verwenden, da dieses Material eine gute Lötfähigkeit und gleichzeitig eine hohe Wärmeleitfähigkeit besitzt.

Weiterhin ist vorteilhaft, wenn die Ausnehmungen der Wärmeleitplatte derart angeordnet sind, daß der auf den durchmetallisierten Bohrungen aufliegende Bereich der Wärmeleitplatte eine kammartige Struktur mit mehrere parallelen Fingern aufweist. Durch eine Optimierung von Breite und Abstand der Finger kann eine gute Wärmeableitung erreicht werden und gleichzeitig sichergestellt werden, daß genügend durchmetallisierte Bohrungen beim Löten mit Lötzinn aufgefüllt werden.

Außerdem ist vorteilhaft, einen nicht mit Ausnehmungen versehenen weiteren Bereich der Wärmeableitplatte vorzusehen. Dieser Bereich kann auf einfache Weise vor dem Löten mit einem Lötstopplack oder einer Folie abgedeckt werden, welche eine Belotung verhindert, und dient bei der Montage der Leiterplatte auf dem Kühlkörper vorteilhaft als ebener Auflagebereich.

Die Wärmeleitplatte kann besonders leicht mit der zweiten Metallisierung der Leiterplatte im Wellenlötverfahren verlötet werden. Hierzu wird der nicht mit den Ausnehmungen versehene Bereich zunächst über eine Klebeschicht auf die zweite Metallisierung aufgeklebt. Die Klebeschicht dient dann vorteilhaft als Positionierhilfe der Wärmeleitplatte beim anschließenden Wellenlöten.

### Zeichnung

Ein Ausführungsbeispiel der Erfindung ist in der Zeichnung dargestellt und wird in der nachfolgenden Beschreibung näher erläutert. Es zeigt
Fig. 1. einen Querschnitt durch eine Leiterplatte und die Wärmleitplatte längs der Schnittlinie I-I in Fig. 2,
Fig. 2 einen Querschnitt durch die auf einen Kühlkörper montierte Leiterplatte längs der Schnittlinie II-II in Fig. 1,
Fig. 3 eine Ansicht der Kühlvorrichtung aus Fig. 2 von unten, ohne den Kühlkörper und die Isolierschicht und vor dem Verlöten der Wärmeleitplatte.

### Beschreibung der Ausführungsbeispiele

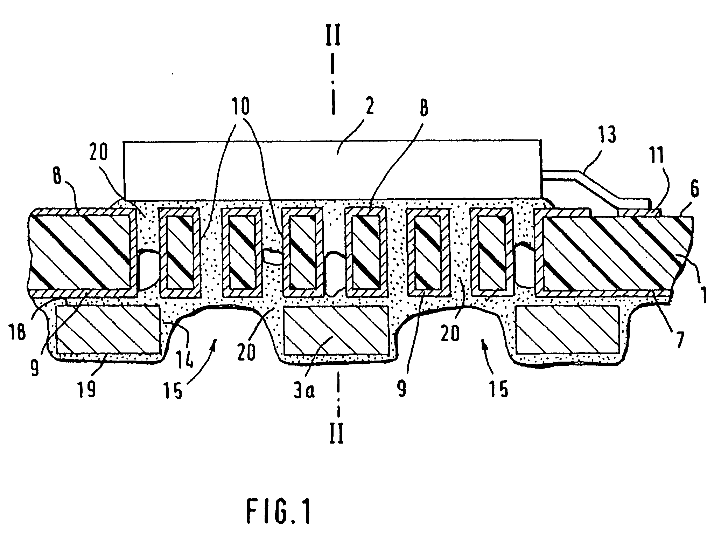

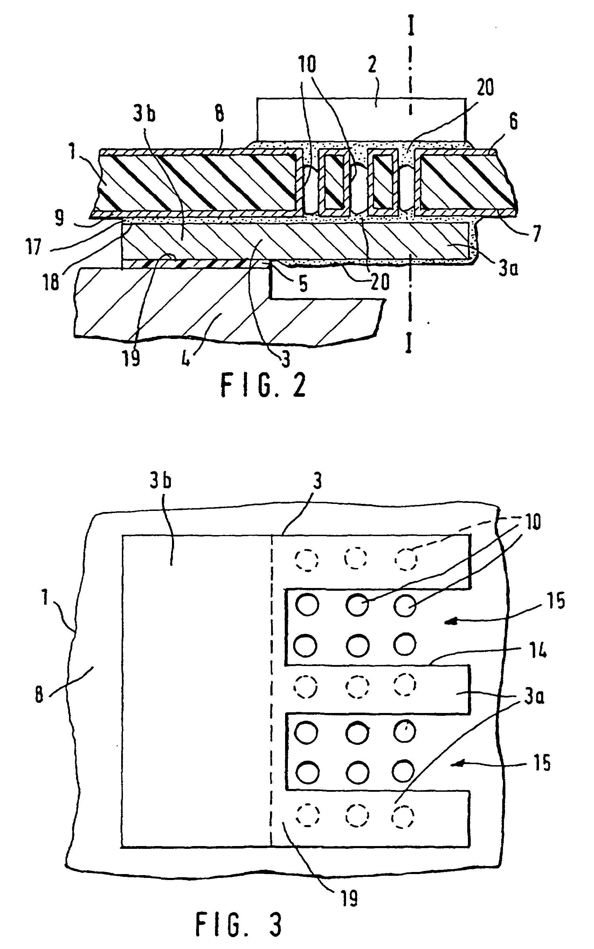

Fig. 1 und Fig. 2 zeigen jeweils einen Querschnitt durch ein erstes Ausführungsbeispiel der erfindungsgemäßen Kühlvorrichtung. Eine doppelt kupferkaschierte Leiterplatte 1 aus Isoliermaterial weist auf ihrer Oberseite 6 neben den für die Verdrahtung von Bauelementen benötigten Leiterbahnen eine erste großflächige Metallisierung 8 auf und auf der Unterseite 7 eine zweite großflächige Metallisierung 9, die beide über eine Vielzahl von durchmetallisierten Bohrungen 10, sogenannte Durchkontaktierungen, galvanisch und wärmeleitend miteinander verbunden sind. Auf der ersten großflächigen Metallisierung 8 ist ein wärmeerzeugendes elektronisches Leistungsbauelement 2 über den durchmetallisierten Bohrungen 10 in bekannter Weise z.B. im Reflow-Lötverfahren direkt aufgelötet. Die Lotauftragung kann dabei so erfolgen, daß Lot 20 wenigstens teilweise in die durchmetallisierten Bohrungen 10 von der Oberseite 6 aus eingefüllt wird. Weiterhin sind Anschlüsse 13 des Bauelementes 2 mit Leiterbahnen 11 auf der Oberseite der Leiterplatte 1 verlötet.

Auf der Unterseite 7 der Leiterplatte 1 ist eine Wärmeleitplatte 3 auf die zweite Metallisierung 9 direkt aufgelötet. Die Wärmeleitplatte ist in Form einer galvanisch verzinnten Kupferplatte ausgebildet, deren Dicke vorzugsweise etwa zwischen 0,5 und 1,5 mm liegen sollte. Es ist aber auch denkbar, ein anderes gut wärmeleitendes Material für die Wärmeleitplatte zu verwenden. Abweichend von dem in den Fig. 1 bis Fig. 3 dargestellten Ausführungsbeispiel kann die Wärmeleitplatte 3 beispielsweise die Form einer einfachen quaderförmigen Platte aufweisen, deren Grundriß dem mit den durchmetallisierten Bohrungen versehenen Bereich der Leiterplatte 1 entspricht. Zur Verlötung der Wärmeleitplatte mit der Leiterplatte wird dann die Leiterplatte 3 beispielsweise mit der Unterseite 7 nach oben gewandt. Anschließend wird auf die nunmehr oben liegende Seite 7 über den durchmetallisierten Bohrungen Lot aufgedruckt, die Wärmeleitplatte 3 auf die Lotpaste aufgesetzt und im Reflowlötverfahren mit der zweiten Metallisierung 9 verlötet. Anschließend wird auf der von der Leiterplatte abgewandten Seite der Wärmeleitplatte 3 die elektrisch isolierende und wärmeleitende Schicht aufgebracht und die Wärmeleitplatte mit der isolierende Schicht auf einen Kühlkörper aufgesetzt.

Bei dem in den Figuren 1 bis 3 dargestellten Ausführungsbeispiel ist die Wärmeleitplatte 3 jedoch im Wellenlötverfahren mit der zweiten Metallisierung 9 verlötet. Da auf der Unterseite 7 der Leiterplatte 1 oft noch weitere Bauelemente vorgesehen sind, die im Wellenlötverfahren mit Anschlüssen auf der Unterseite verlötet werden sollen, hat dies den Vorteil, daß die Verlötung der Wärmeleitplatte 3 zusammen mit der Verlötung dieser Bauelemente erfolgen kann. Bei dem in Fig. 1 bis Fig. 3 dargestellten Ausführungsbeispiel weist die Wärmeleitplatte 3 eine quaderförmige Grundform auf, in der zwei rechteckförmige Ausnehmungen 15 vorgesehen sind, die durch drei Finger 3a begrenzt werden, die von einem nicht mit Ausnehmungen versehenen Bereich 3b seitlich abstehen. Die Ausnehmungen 15 sind durch die Wärmeleitplatte von deren Oberseite 18 bis zu deren Unterseite 19 hindurchgeführt. Wie am besten in Fig. 3 zu erkennen ist, weist die Wärmeleitplatte 3 einen E-förmigen Grundriß auf. Die mit den Ausnehmungen versehene Wärmeleitplatte kann aber auch eine andere Form aufweisen. Insbesondere ist es möglich, die Anzahl der Finger 3a an die Anzahl der Durchkontaktierungen anzupassen. Vorteilhaft ist, wenn der mit den Ausnehmungen versehene Bereich der Wärmeleitplatte mindestens die Größe des mit den Durchkontaktierungen 10 versehenen Bereiches der Leiterplatte aufweist.

Die Wärmeleitplatte 3 kann folgendermaßen an der Leiterplatte 1 befestigt werden. Zunächst wird auf die Oberseite 18 des nicht mit den Ausnehmungen versehenen, in Fig. 3 links von der gestrichelten Linie angeordneten Bereichs 3b ein Kleber 17 aufgetragen und anschließend die Wärmeleitplatte 3 mit ihrer Oberseite 18 auf die Metallisierung 9 auf der Unterseite 7 der Leiterplatte aufgeklebt. Dabei ist darauf zu achten, daß der Bereich 3b nicht auf die durchmetallisierten Bohrungen 10 aufgeklebt wird und daß der mit den Ausnehmungen 15 versehene, in Fig. 3 rechts von der gestrichelten Linie dargestellte Bereich über den durchmetallisierten Bohrungen 15 angeordnet wird. Die Klebeschicht 17 dient der Halterung der Wärmeleitplatte beim anschließenden Wellenlöten und wird sehr dünn aufgetragen. Durch die Klebeschicht 17 ist die Wärmeleitplatte durch einen sehr schmalen Spalt von der zweiten Metallisierung 9 beabstandet. Weiterhin wird ein Lötstopplack oder ein anderes geeignetes Mittel auf die Unterseite 19 des nicht mit den Ausnehmungen versehenen Bereichs 3b aufgetragen. Der Lötstopplack kann auch bereits vor der Verklebung der Wärmeleitplatte aufgetragen werden. Die mit der Wärmeleitplatte versehene Leiterplatte wird anschließend einer Wellenlötstation zugeführt. Beim Wellenlöten verhindert der Lötstopplack eine Lotabscheidung auf dem nicht mit den Ausnehmungen 15 versehenen Bereich 3b der Unterseite 19 der Wärmeleitplatte, während sich auf der Unterseite 19 im Bereich der Finger 3a Lot abscheidet. Wie besonders gut in Fig. 1 zu erkennen ist, dringt Lötzinn 20 weiterhin auch in die Ausnehmungen 15 und in den schmalen Spalt zwischen der zweiten Metallisierung 9 und der Oberseite 18 der Wärmeleitplatte ein. Außerdem füllen sich die durchmetallisierten Bohrungen 10 mit Lötzinn. Vorzugsweise werden zumindest die durch die Ausnehmungen 15 zugänglichen Bohrungen 10 vollständig mit Lötzinn aufgefüllt. Dabei bilden sich Lotbrücken aus, welche die Durchkontaktierungen 10 mit der Innenwandung 14 der Ausnehmungen 15 sehr gut wärmeleitend verbinden. Nach der Verlötung wird der Lötstopplack entfernt und an seiner Stelle eine elektrisch isolierende und gut wärmeleitende Schicht 5 auf den nicht mit den Durchkontaktierungen versehenen Bereich 3b auf der Unterseite 19 der Wärmeleitplatte aufgebracht. Wird ein Lötstopplack verwendet, der eine ausreichende Wärmeleitfähigkeit und elektrisch isolierende Eigenschaften besitzt, so kann dieser auch als Isolierschicht 5 vorgesehen sein, wodurch ein Herstellungsschritt eingespart wird. Anschließend wird die Leiterplatte 1 mit der Wärmeleitplatte 3, wie in Fig. 2 gezeigt, auf einen Kühlkörper 4 aufgesetzt. Der Kühlkörper 4 weist einen erhabenen Bereich auf, welcher als Auflagebereich für die Isolierschicht 5 dient. Unterhalb der Fingerbereiche 3a weist der Kühlkörper 4 eine Absenkung auf, so daß sicher gestellt ist, daß das auf den Fingern 3a abgeschiedene Lot 20 nicht den Kühlkörper berühren kann. Die Isolierschicht 5 kann auch als Klebeschicht oder Klebefolie ausgebildet sein und damit zugleich der mechanischen Halterung der Leiterplatte auf dem Kühlkörper dienen.

Durch die in Fig. 1 und 2 dargestellt Anordnung wird eine sehr effektive Einkopplung der durch die Durchkontaktierungen 10 abgeleiteten Wärme auf die Fingerbereiche 3a der Wärmeleitplatte 3 erreicht. Die die Ausnehmungen 15 begrenzenden Finger 3a leiten die Wärme auf den Bereich 3b ab. Dort verteilt sich die Wärme und gelangt über die elektrisch isolierende Schicht 5 auf den Kühlkörper 4. Je breiter die Fingerbereiche 3a ausgebildet sind, desto besser ist die laterale Wärmeableitung auf den Bereich 3b. Andererseits sollten die Finger nicht zu breit sein, da ansonsten zu viele Durchkontaktierungen 10 nicht mit Lot gefüllt werden. Für die jeweilige Anwendung muß hier ein Kompromiß gefunden werden. Bei dem hier dargestellten Ausführungsbeispiel wurden die Breite der Finger 3a etwa schmaler als die Breite der Ausnehmungen 15 ausgelegt.

Anders als in den Fig. 1 und 2 dargestellten Ausführungsbeispiel ist es auch möglich, die Klebeschicht 17 entfallen zulassen und statt dessen die Wärmeleitplatte 3 mit einer auf der Unterseite 9 über dem Bereich 3b aufgeklebten Klebefolie an der Unterseite 7 der Leiterplatte 1 festzukleben. Die Klebefolie schützt in diesem Fall zugleich die Unterseite 19 des Bereichs 3b vor einer Belotung in der Wellenlötstation. Beim Löten dringt Lot 20 in die Ausnehmungen 15 und die Durchkontierungen 10 ein, wodurch die Wärmeleitplatte mit der zweiten Metallisierung 9 verlötet wird. In diesem Fall liegt die Oberseite 18 der Wärmeleitplatte direkt auf der zweiten Metallisierung 9 auf.

## Patentansprüche

1. Kühlvorrichtung, insbesondere zur Verwendung in einem elektronischen Steuergerät, umfassend eine auf einem Kühlkörper (4) aufgebrachte Leiterplatte (1), die auf einer ersten Seite (6) mit wenigstens einem auf einer ersten großflächigen Metallisierung (8) angeordneten, wärmeerzeugenden Bauelement (2) versehen ist und die auf einer dem Bauelement gegenüberliegenden zweiten Seite (7) eine zweite großflächige Metallisierung (9) aufweist, die im Montagebereich des Bauelementes (2) mit der ersten großflächigen Metallisierung (8) über durchmetallisierte Bohrungen (10) wärmeleitend verbunden ist, wobei zwischen der zweiten Seite (7) der Leiterplatte (1) und dem Kühlkörper (4) eine elektrisch isolierende und wärmeleitende schicht (5) angeordnet ist **dadurch gekennzeichnet, daß** umindest auf den mit den durchmetallisierten Bohrungen (10) versehenen Bereich der zweiten großflächigen Metallisierung (9) eine als Wärmesenke dienende Wärmeleitplatte (3) aufgelötet ist, auf deren von der Leiterplatte (1) abgewandten Seite (19) die elektrisch isolierende und wärmeleitende Schicht (5) angeordnet ist dass der auf den durchmetallisierten Bohrungen (10) aufliegende Bereich der Wärmeleitplatte (3) mit wenigstens einer sich durch die Wärmeleitplatte erstreckenden Ausnehmung (15) versehen ist.

2. Kühlvorrichtung nach Anspruch 1, **dadurch gekennzeichnet, daß** die Wärmeleitplatte (3) eine vorzugsweise aus Kupfer bestehende Metallplatte ist.

3. Kühlvorrichtung nach Anspruch 1, **dadurch gekennzeichnet, daß** die Wärmleitplatte (3) mit mehreren Ausnehmungen (15) derart versehen ist, daß der auf den durchmetallisierten Bohrungen (10) angeordnete Bereich der Wärmeleitplatte (3) eine kammartige Struktur mit mehreren parallel zueinander verlaufenden Fingern (3a) aufweist.

4. Kühlvorrichtung nach einem der vorstehenden Ansprüche, **dadurch gekennzeichnet, daß** in die wenigstens eine Ausnehmung (15) der Wärmeleitplatte (3) Lötzinn (20) eingebracht ist, wobei das Lötzinn die Innenwandung (14) der Ausnehmung (15) bedeckt und wenigstens in die durch die Ausnehmung (15) zugänglichen durchmetallisierten Bohrungen (10) zumindest teilweise eingebracht ist.

5. Kühlvorrichtung nach Anspruch 4, **dadurch gekennzeichnet, daß** die Warmeleitplatte (3) zusätzlich einen nicht mit Ausnehmungen (15) versehenen Bereich (3b) aufweist, auf dessen von der Leiterplatte abgewandten Seite (19) die elektrisch isolierende, wärmeleitende Schicht (5) angeordnet ist.

6. Kühlvorrichtung nach Anspruch 5, **dadurch gekennzeichnet, daß** zwischen der zweiten Seite (7) der Leiterplatte (1) und dem nicht mit Ausnehmungen (15) versehenen Bereich (3b) der Wärmeleitplatte (3) eine Klebeschicht (17) vorgesehen ist.

7. Kühlvorrichtung nach einem der vorstehenden Ansprüche, **dadurch gekennzeichnet, daß** die Wärmeleitplatte (3) im Wellenlötverfahren auf die zweite Seite (7) der Leiterplatte (1) aufgelötet ist.

## Claims

1. Cooling apparatus, in particular for use in an electronic controller, having a printed circuit board (1) which is mounted on a heat sink (4), is provided on a first face (6) with at least one component (2) which produces heat and is arranged on a first large-area metallization (8) and which printed circuit board (1) has second large-area metallization (9) on a second face (7) opposite the component, which is thermally conductively connected in the mounting area of the component (2) to the first large-area metallization (8) via through-plated holes (10), with an electrically insulating and thermally conductive layer (5) being arranged between the second face (7) of the printed circuit board (1) and the heat sink (4), **characterized in that** a thermally conductive plate (3) which acts as a heat sink is soldered to that area of the second large-area metallization (9) which is provided with the through-plated holes (10), and the electrically insulating and thermally conductive layer (5) is arranged on the side (19) of the thermally conductive plate (3) which faces away from the printed circuit board (1), and that area of the thermally conductive plate (3) which rests on the through-plated holes (10) is provided with at least one recess (15), which extends through the thermally conductive plate.

2. Cooling apparatus according to Claim 1, **characterized in that** the thermally conductive plate (3) is a metal plate that is preferably composed of copper.

3. Cooling apparatus according to Claim 1, **characterized in that** the thermally conductive plate (3) is provided with a number of recesses (15) in such a way that the area of the thermally conductive plate (3) which is arranged on the through-plated holes (10) has a comb-like structure with a number of fingers (3a) running parallel to one another.

4. Cooling apparatus according to one of the preceding claims, **characterized in that** solder tin (20) is introduced into the at least one recess (15) in the thermally conductive plate (3) with the solder tin covering the inner wall (14) of the recess (15) and being at least partially introduced into the through-plated holes (10), which are accessible through the recess (15).

5. Cooling apparatus according to Claim 4, **characterized in that** the thermally conductive plate (3) additionally has an area (3b) which is not provided with recesses (15) and on whose face (19) which faces away from the printed circuit board the electric insulating, thermally conductive layer (5) is arranged.

6. Cooling apparatus according to Claim 5, **characterized in that** an adhesive layer (17) is provided between the second face (7) of the printed circuit board (1) and that area (3b) of the thermally conductive plate (3) which is not provided with recesses (15).

7. Cooling apparatus according to one of the preceding claims, **characterized in that** the thermally conductive plate (3) is soldered onto the second face (7) of the printed circuit board (1) using the wave soldering process.

## Revendications

1. Dispositif de refroidissement, notamment utilisé dans un appareil de commande électronique, comprenant un circuit imprimé (1) appliqué sur un corps de refroidissement (4), avec sur un premier côté (6) au moins un composant (2) générant de la chaleur et disposé sur une première métallisation (8) de grande surface, et sur un deuxième côté (7) opposé au composant une deuxième métallisation de grande surface (9) reliée par conduction thermique à la première métallisation de grande surface (8) dans la zone de montage du composant (2) par des alésages (10) métallisés, une couche (5) conductrice de chaleur et isolante électrique étant placée entre le deuxième côté (7) du circuit imprimé (1) et le corps de refroidissement (4),
**caractérisé en ce qu'**
une plaque conductrice de chaleur (3), servant de dissipateur de chaleur et dont le côté (19) détourné du circuit imprimé (1) loge la couche (5) conductrice de chaleur et isolante électrique, est brasée au moins sur la zone dotée d'alésages métallisés (10), et la zone de la plaque conductrice de chaleur (3) se trouvant sur les alésages métallisés (10) est pourvue d'au moins un évidement (15) traversant la plaque conductrice de chaleur.

2. Dispositif de refroidissement selon la revendication 1,
**caractérisé en ce que**
la plaque conductrice de chaleur (3) est une plaque métallique de préférence en cuivre.

3. Dispositif de refroidissement selon la revendication 1,
**caractérisé en ce que**
la plaque conductrice de chaleur (3) est pourvue de plusieurs évidements (15) de manière à ce que la zone de la plaque conductrice de chaleur (3) disposée sur les alésages métallisés (10) présente une structure de type en peigne dotée de plusieurs doigts (3a) s'étendant parallèlement les uns aux autres.

4. Dispositif de refroidissement selon l'une quelconque des revendications précédentes,
**caractérisé en ce que**
de l'étain de brasage (20) est placé dans au moins un évidement (15) de la plaque conductrice de chaleur (3), cet étain recouvrant la paroi intérieure (14) de l'évidement (15) et étant appliqué, au moins partiellement, au moins dans les alésages (10) métallisés accessibles par l'évidement (15).

5. Dispositif de refroidissement selon la revendication 4,
**caractérisé en ce que**
la plaque conductrice de chaleur (3) présente de plus une zone (3b) non pourvue d'évidements (15) et dont le côté (19) opposé au circuit imprimé accueille la couche (5) conductrice de chaleur et isolante électrique.

6. Dispositif de refroidissement selon la revendication 5,
**caractérisé en ce qu'**
une couche de colle (17) est prévue entre le deuxième côté (7) du circuit imprimé (1) et la zone (3b) de la plaque conductrice de chaleur (3) non pourvue d'évidements (15).

7. Dispositif de refroidissement selon l'une quelconque des revendications précédentes,
**caractérisé en ce que**
la plaque conductrice de chaleur (3) est brasée sur le deuxième côté (7) du circuit imprimé (1) par un procédé de brasage à la vague.
